# EUROPÄISCHE PATENTSCHRIFT

(11) **EP 3 485 500 B1**
(45) Veröffentlichungstag und Bekanntmachung des Hinweises auf die Patenterteilung: **30.12.2020**
(21) Anmeldenummer: 17739557.1
(22) Anmeldetag: 13.07.2017
(51) Int. Cl.: H01H 3/02, G01D 5/241, H03K 17/975, H01H 3/00

(54) **SCHALTBEDIENELEMENT**
SHIFT OPERATING ELEMENT
ELÉMENT DE COMMANDE

(30) Priorität: 15.07.2016 DE 102016008498
(43) Veröffentlichungstag der Anmeldung: 22.05.2019
(73) Patentinhaber: Marquardt GmbH, 78604 Rietheim-Weilheim (DE)
(72) Erfinder: MINK, Achim, 78652 Deißlingen (DE); NEITZEL, Roland, 78570 Mühlheim (DE)
(74) Vertreter: Jostarndt Patentanwalts-AG
(86) Internationale Anmeldenummer: PCT/EP2017/067654
(87) Internationale Veröffentlichungsnummer: WO 2018/011325

(56) Entgegenhaltungen:
- EP-A1- 2 629 422
- EP-A1- 2 911 300
- WO-A1-03/063193
- DE-A1-102013 021 575
- GB-A- 2 077 512

## Beschreibung

Die Erfindung betrifft ein Schaltbedienelement nach dem Oberbegriff des Patentanspruchs 1. Das Schaltbedienelement kann zur manuellen Betätigung insbesondere in einem Kraftfahrzeug eingesetzt werden.

Ein solches Schaltbedienelement weist eine Betätigungsfläche auf, die durch manuelle Krafteinwirkung mittels eines Elements durch den Benutzer bewegbar ist. Insbesondere kann es sich bei dem Element um den Finger einer menschlichen Hand handeln, mit dessen Hilfe die Betätigung des Schaltbedienelements erfolgt. Die Betätigungsfläche wirkt dabei mit einem Sensor derart zusammen, dass der Sensor bei Bewegung der Betätigungsfläche mittels des Elements ein Signal erzeugt. Das Signal dient insbesondere zum Schalten und/oder Auslösen einer dem Schaltbedienelement zugeordneten Funktion in der Art eines Schaltsignals. Zur Rückstellung der Betätigungsfläche in die Ausgangsstellung dient eine Feder als Rückstellelement. Der Sensor sowie die Feder erfordern einen gewissen Bauraum im Schaltbedienelement, welcher allerdings oft begrenzt ist.

Schaltbedienelemente nach dem Stand der Technik sind beispielsweise in den Druckschriften EP 2 629 422 A1, die ein Schaltbedienelement nach dem Oberbegriff des Anspruchs 1 offenbart, DE 10 2013 021575 A1, GB 2 077 512 A, WO 03/063193 A1 und EP 2 911 300 A1 beschrieben.

Der Erfindung liegt die Aufgabe zugrunde, das Schaltbedienelement im Hinblick auf dessen Kompaktheit weiterzuentwickeln.

Diese Aufgabe wird bei einem gattungsgemäßen Schaltbedienelement durch die kennzeichnenden Merkmale des Anspruchs 1 gelöst.

Beim erfindungsgemäßen Schaltbedienelement ist ein mit der Betätigungsfläche bei deren Bewegung zusammenwirkendes Dämpfungs- und/oder Rückstellelement vorgesehen, wobei das Dämpfungs- und/oder Rückstellelement ein Bestandteil des Sensors ist. Insbesondere ist zweckmäßigerweise das Dämpfungs- und/oder Rückstellelement in den Sensor und/oder der Sensor in das Dämpfungs- und/oder Rückstellelement integriert. In vorteilhafter Weise bietet das Schaltbedienelement eine gute Haptik bei geringen Abmessungen. Weitere Ausgestaltungen der Erfindung sind Gegenstand der Unteransprüche.

In weiterer Ausgestaltung kann ein Betätigungselement an der Betätigungsfläche zur Herstellung der Wirkverbindung zum Sensor angeordnet sein. Das Betätigungselement kann in einfacher Art und Weise auf das Dämpfungs- und/oder Rückstellelement einwirken. Die Anordnung kann so ausgestaltet sein, dass das Dämpfungs- und/oder Rückstellelement sich bei Krafteinbringung auf die Betätigungsfläche in etwa planparallel bewegt. Bei Bewegung der Betätigungsfläche kann dabei das Betätigungselement mit dem Dämpfungs- und/oder Rückstellelement zur Signalerzeugung zusammenwirken.

Zur Einsparung von Einzelteilen dient das Dämpfungs- und/oder Rückstellelement als eine erste elektrische Sensorelektrode für den Sensor . Es kann eine weitere elektrische Sensorelektrode für den Sensor vorgesehen sein, derart dass die beiden Sensorelektroden einen kapazitiven Sensor bilden. Die durch die Bewegung des Dämpfungs- und/oder Rückstellelements bewirkte Abstandsänderung der beiden Sensorelektroden zueinander kann die Kapazität des Sensors verändern. In einfacher Art und Weise kann die Veränderung der Kapazität ausgewertet werden und für die Erzeugung des Signals dienen. Ein solcherart ausgestaltetes Schaltbedienelement ist aufgrund der geringen Anzahl von Einzelteilen besonders kostengünstig und ist funktionssicher betreibbar.

Der einfachen Montierbarkeit halber kann eine Leiterplatte vorgesehen sein, wobei das Dämpfungs- und/oder Rückstellelement an und/oder auf der Leiterplatte angeordnet sein kann. Das Dämpfungs- und/oder Rückstellelement kann mit der Leiterplatte zur Ausbildung der ersten Sensorelektrode in elektrischer Kontaktierung angeordnet sein. Zweckmäßigerweise kann die zweite Sensorelektrode durch Leiterbahnen, die insbesondere in der Art von Kupferflächen ausgestaltet sein können, auf der Leiterplatte gebildet sein. Die erste Sensorelektrode am Dämpfungs- und/oder Rückstellelement kann dann bei Krafteinwirkung auf die Betätigungsfläche sich in etwa planparallel zur zweiten Sensorelektrode auf der Leiterplatte bewegen.

Bei dem Dämpfungs- und/oder Rückstellelement kann es sich um ein mechanisches Dämpfungs- und/oder Rückstellelement handeln, welches sich durch Einfachheit sowie auch Kostengünstigkeit auszeichnet. In funktionssicherer Art und Weise ist das Dämpfungs- und/oder Rückstellelement als ein elastisches Element, insbesondere in der Art eines Federelements, mit Kontaktflächen für die elektrische Kontaktierung ausgestaltet. In bevorzugter Weise kann das Federelement wiederum als eine Blattfeder ausgestaltet sein. In einfacher Art und Weise kann das elastische Element in etwa H-förmig ausgestaltete Kontaktflächen für die elektrische Kontaktierung zur Leiterplatte aufweisen. Des Weiteren kann die Verbindungsfläche der Kontaktflächen elastische Federarme umfassen.

An der Verbindungsfläche der Kontaktflächen, und zwar insbesondere an den Federarmen, sind in etwa mittig zwei einander gegenüberliegende, in etwa rechteckförmige Flächen für die Zusammenwirkung mit dem Betätigungselement angeordnet. Diese Fläche bildet die erste Sensorelektrode . Des Weiteren ist eine Noppe an der Fläche zur Zusammenwirkung mit einem Zapfen am Betätigungselement angeordnet, womit eine feinfühlige Bedienung des Schaltbedienelementes gegeben ist.

Das Dämpfungs- und/oder Rückstellelement kann aus Metall bestehen, wodurch eine lange Lebensdauer gegeben ist. Der einfachen Herstellbarkeit halber kann es sich anbieten, dass das Dämpfungs- und/oder Rückstellelement in der Art eines Stanz-Biege-Teils hergestellt ist.

Zum Schutz vor äußeren Einflüssen kann ein Gehäuse für das Schaltbedienelement vorgesehen sein. Die Betätigungsfläche kann eine Oberfläche am Gehäuse bilden. Aufgrund der erfindungsgemäßen Ausgestaltung des Schaltbedienelementes kann die Betätigungsfläche eine weitgehend geschlossene Oberfläche am Gehäuse ausbilden. Das Dämpfungs- und/oder Rückstellelement und/oder die Leiterplatte können wiederum im Inneren des Gehäuses befindlich sein. Anstelle der Ausgestaltung als ein kapazitiver Sensor kann das Dämpfungs- und/oder Rückstellelement auch ein Bestandteil eines induktiven Sensors, eines Magnetsensors, eines Hallsensors o. dgl. sein.

Für eine besonders bevorzugte Ausgestaltung des erfindungsgemäßen Schaltbedienelements ist nachfolgendes festzustellen.

Bei modernen Bedienelementen in der Art eines Human Machine Interface (HMI) im Automobil sind vermehrt geschlossene Bedienflächen vorzufinden. Diese Bedienflächen können mit mehreren Funktionen belegt sein. Die Funktionsauswahl kann über eine kapazitive Sensorik, die hinter der Bedienfläche angebracht ist, erfasst werden. Die Freigabe der Funktion kann über eine Kraft erfolgen, die auf die Bedienfläche eingebracht wird. Diese Kraft erzeugt ein Absenken der gesamten Bedienfläche. Die Wegänderung der Bedienfläche soll dabei möglichst gering sein.

Die mechanische Dämpfung und die Erfassung der Wegänderung werden in der Regel durch zwei getrennte Systeme erzielt. Der Bauraum, der für die Komponenten zur Verfügung steht, ist oft sehr begrenzt. Es stellt sich die Aufgabe, ein Element zu entwerfen, das sowohl die mechanische Dämpfung und/oder die Rückstellung der Bedienfläche ermöglicht und auch zur Erfassung der Wegänderung dient. Das Element soll so ausgebildet sein, dass eine optimale sensorische Erfassung und Auswertung möglich ist.

Geschaffen ist ein Haptikelement mit sensorischer Funktion, wobei ein mechanisches Dämpfungs- und/oder Rückstellelement gleichzeitig als Sensor dient. Das Dämpfungs- und/oder Rückstellelement wird auf eine Leiterplatte montiert und elektrisch kontaktiert. Eine separate Sensorelektrode wird auf der Platine durch Leiterbahnen in der Art von Kupferflächen gebildet. Das Dämpfungs- und/oder Rückstellelement bildet mit der Sensorelektrode eine elektrische Kapazität. Der Abstand vom Dämpfungs- und/oder Rückstellelement zum Sensorelement beeinflusst die Kapazität. Das Dämpfungs- und/oder Rückstellelement senkt sich bei Krafteinbringung planparallel zur Leiterplatte ab und erzeugt dadurch eine Änderung der Kapazität. Diese Kapazitätsänderung wird elektrisch ausgewertet und dient als Maß für die Krafteinbringung. Der kapazitive Sensor kann auch durch einen induktiven Sensor oder durch andere detektierbare Sensoren ersetzt werden. Die mit der Erfindung erzielten Vorteile bestehen insbesondere darin, dass eine Einsparung von Komponenten und/oder eine Reduzierung des benötigten Bauraums ermöglicht werden. Das Dämpfungs- und/oder Rückstellelement kann zusätzlich als ein Wegsensor benutzt werden. Mittels der Wegänderung lässt sich in einfacher sowie zuverlässiger Art und Weise die aufgebrachte Kraft bestimmen sowie die kapazitive Änderung detektieren, auswerten und als Signal ausgeben.

Ein Ausführungsbeispiel der Erfindung mit verschiedenen Weiterbildungen und Ausgestaltungen ist in den Zeichnungen dargestellt und wird im folgenden näher beschrieben. Es zeigen
- Fig. 1: ein Schaltbedienelement für ein Kraftfahrzeug in perspektivischer Ansicht,
- Fig. 2: einen Schnitt durch das ein Dämpfungs- und/oder Rückstellelement aufweisende Schaltbedienelement entlang der Linie 2-2 in Fig. 1 und
- Fig. 3: das Dämpfungs- und/oder Rückstellelement aus Fig. 2 in Drauf- und Seitenansicht.

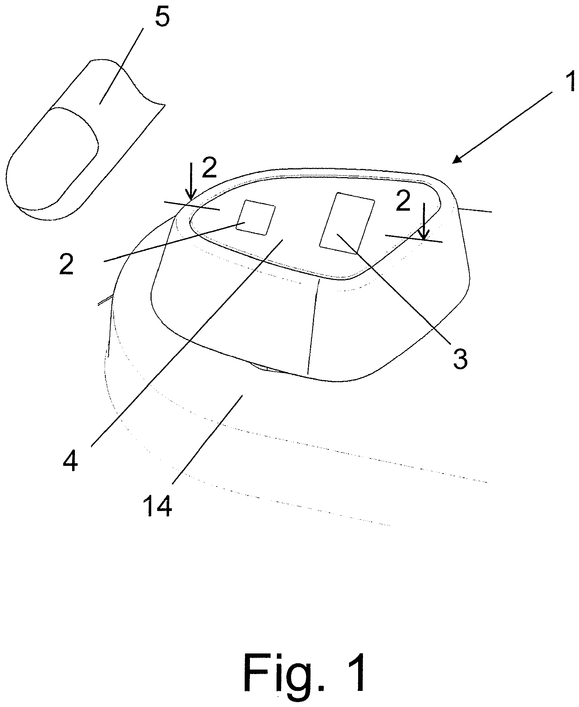

In Fig. 1 ist eine Schaltbedienelement 1 für ein Kraftfahrzeug zu sehen, mit dessen Hilfe eine Funktion im Kraftfahrzeug auslösbar und/oder bedienbar ist. Beispielsweise kann das Schaltbedienelement 1 zur Bedienung des Gebläses im Kraftfahrzeug dienen. Am Schaltbedienelement 1 ist ein Funktionssymbol 2 zur Darstellung der mittels des Schaltbedienelementes 1 auslösbaren Funktion sowie eine Funktionsanzeige 3 zur Darstellung des Zustandes (Ein / Aus) der jeweiligen Funktion angeordnet, wobei das Funktionssymbol 2 sowie die Funktionsanzeige 3 beleuchtbar sind.

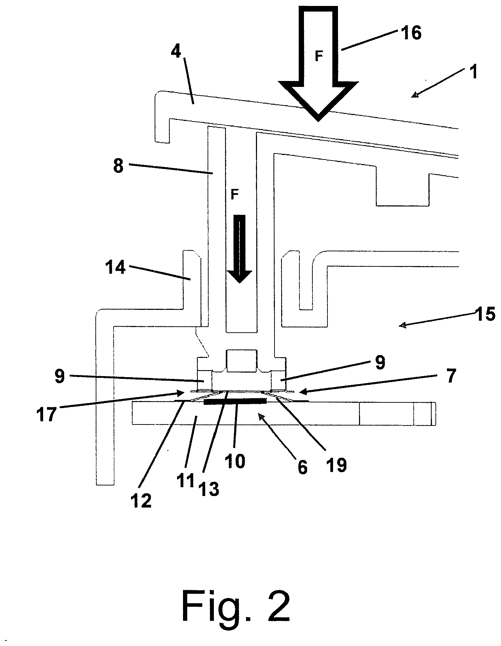

Das Schaltbedienelement 1 weist ein Gehäuse 14 und eine Betätigungsfläche 4 auf, wobei die Betätigungsfläche 4 an einer Oberfläche am Gehäuse 14 bewegbar angeordnet ist. Die Betätigungsfläche 4 bildet damit eine Oberfläche am Gehäuse 14, wobei die Oberfläche weitgehend geschlossen ist, so dass ein Eindringen von Schadstoffen ist das Innere 15 (siehe Fig. 2) des Gehäuses 14 wirksam verhindert ist. Auf die Betätigungsfläche 4 kann manuell mittels eines Elements 5 zur Bedienung des Schaltbedienelements 1 mit einer Kraft 16 (siehe Fig. 2) eingewirkt werden. Insbesondere kann es sich bei dem Element 5 um den Finger einer menschlichen Hand handeln. Mit der Betätigungsfläche 4 wirkt ein Sensor 6 (siehe Fig. 2) derart zusammen, dass der Sensor 6 bei Bewegung der Betätigungsfläche 4 mittels des Elements 5 ein Signal erzeugt. Dieses Signal dient dann zum Schalten und/oder Auslösen einer zugehörigen Funktion für das Kraftfahrzeug in der Art eines Schaltsignals.

Wie weiter in Fig. 2 zu sehen ist, ist im Gehäuse 14 ein mit der Betätigungsfläche 4 bei deren Bewegung aufgrund der Einwirkung der Kraft 16 zusammenwirkendes, mechanisches Dämpfungs- und/oder Rückstellelement 7 angeordnet. Das Dämpfungs- und/oder Rückstellelement 7 dient zum einen zur Rückstellung der Betätigungsfläche 4 in deren Ausgangsposition, wenn die Einwirkung der Kraft 16 beendet ist. Zum anderen dient das Dämpfungs- und/oder Rückstellelement 7 zur Dämpfung der Bewegung der Betätigungsfläche 4 bei Einwirkung der Kraft 16, um für den Benutzer eine entsprechende Haptik bei der Bedienung des Schaltbedienelements 1 bereitzustellen. Das Dämpfungs- und/oder Rückstellelement 7 ist ein Bestandteil des Sensors 6, und zwar ist das mechanische Dämpfungs- und/oder Rückstellelement 7 in den Sensor 6 integriert. Selbstverständlich kann auch umgekehrt der Sensor 6 in das Dämpfungs- und/oder Rückstellelement 7 integriert sein. Zwecks Zusammenwirkung mit der Betätigungsfläche 4 ist ein die Kraft 16 übertragendes Betätigungselement 8 an der Betätigungsfläche 4 angeordnet, wobei das Betätigungselement 8 auf das Dämpfungs- und/oder Rückstellelement 7 mittels eines Zapfens 9 einwirkt. Es können dabei mehrere Zapfen 9 derart am Betätigungselement 8 angeordnet sein, dass das Dämpfungs- und/oder Rückstellelement 7 sich bei Einbringung der Kraft 16 auf die Betätigungsfläche 4 in etwa planparallel zur Signalerzeugung bewegt.

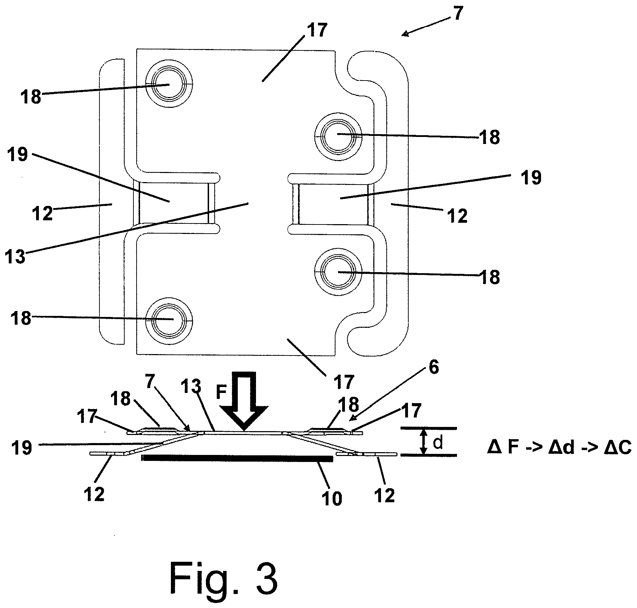

Wie bereits ausgeführt, ist das mechanische Dämpfungs- und/oder Rückstellelement 7 ein Bestandteil des Sensors 6. Hierzu umfasst das Dämpfungs- und/oder Rückstellelement 7 eine erste elektrische Sensorelektrode 17 für den Sensor 6. Es ist eine weitere, zweite elektrische Sensorelektrode 10 für den Sensor 6 vorgesehen, derart dass die beiden Sensorelektroden 17, 10 einen kapazitiven Sensor bilden. Wie man der Seitenansicht in Fig. 3 entnimmt, besitzen die beiden Sensorelektroden 17, 10 in unbelasteten Zustand einen Abstand d zueinander. Die durch die Bewegung des Dämpfungs- und/oder Rückstellelements 7 aufgrund der Einwirkung der Kraft 16 als Kraftänderung ΔF bewirkte Abstandsänderung Δd der beiden Sensorelektroden 17, 10 zueinander, verändert die elektrische Kapazität des Sensors 6. Diese Veränderung der Kapazität des Sensors 6 wird ausgewertet, wobei dann die Kapazitätsveränderung ΔC für die Erzeugung des Signals dient.

Gemäß Fig. 2 ist im Gehäuse 14 weiter eine Leiterplatte 11 vorgesehen, an und/oder auf der das Dämpfungs- und/oder Rückstellelement 7 angeordnet ist. Das Dämpfungs- und/oder Rückstellelement 7 ist mit der Leiterplatte 11 zur Ausbildung der ersten Sensorelektrode 17 elektrisch kontaktiert. Die zweite Sensorelektrode 10 ist durch Leiterbahnen in der Art von Kupferflächen auf der Leiterplatte 11 gebildet. Wie man anhand der Fig. 2 erkennt, bewegt sich somit die erste Sensorelektrode 17 am Dämpfungs- und/oder Rückstellelement 7 bei Krafteinwirkung auf die Betätigungsfläche 4 in etwa planparallel zur zweiten Sensorelektrode 10 auf der Leiterplatte 11. Das Dämpfungs- und/oder Rückstellelement 7 und/oder die Leiterplatte 11 sind vor Fremdeinflüssen geschützt im Inneren 15 des Gehäuses 14 befindlich.

Wie man weiter der Fig. 3 entnimmt, ist das Dämpfungs- und/oder Rückstellelement 7 als ein elastisches Element 7 in der Art eines Federelements, und zwar genauer in der Art einer Blattfeder ausgestaltet. Am Dämpfungs- und/oder Rückstellelement 7 sind Kontaktflächen 12 für die elektrische Kontaktierung zur Leiterplatte 11 angeordnet. Entsprechend der Draufsicht auf das Dämpfungs- und/oder Rückstellelement 7 sind die Kontaktflächen 12 in etwa H-förmig ausgestaltet, wobei die Verbindungsfläche 13 der Kontaktflächen 12 elastische Federarme 19 umfasst. An der ausbauchartig verlaufenden Verbindungsfläche 13 der Kontaktflächen 12 sind in etwa mittig zwei einander gegenüberliegende, in etwa rechteckförmige Flächen 17 für die Zusammenwirkung mit dem Betätigungselement 8 angeordnet. Die Flächen 17 bilden, gegebenenfalls zusammen mit der Verbindungsfläche 13, die erste Sensorelektrode 17.

Und zwar wirkt das Betätigungselement 8 mit jeweils zwei Zapfen 9 auf zwei dazu korrespondierende Noppen 18 an der jeweiligen Fläche 17 ein. Da das Dämpfungs- und/oder Rückstellelement 7 zwei solcher Flächen 17 aufweist, wirken somit insgesamt vier Zapfen 9 in etwa an Eckpunkten der rechteckförmigen Fläche 17 bei Bewegung der Betätigungsfläche 4 mit dem Dämpfungs- und/oder Rückstellelement 7 zusammen, so dass die weitgehend planparallele Bewegung der Betätigungsfläche 4 sowie des Dämpfungs- und/oder Rückstellelements 7 gewährleistet ist. Das Dämpfungs- und/oder Rückstellelement 7 besteht aus Metall und ist in der Art eines Stanz-Biege-Teils hergestellt.

Vorliegend ist ein kapazitiv arbeitender Sensor 6 für das Schaltbedienelement 1 beschrieben. Selbstverständlich kann der Sensor auch auf einem anderen Sensorprinzip beruhen, beispielsweise kann das Dämpfungs- und/oder Rückstellelement ein Bestandteil eines induktiven Sensors, eines Magnetsensors, eines Hallsensors o. dgl. sein, was jedoch nicht weiter gezeigt ist. Weiter ist die Erfindung nicht auf das beschriebene und dargestellte Ausführungsbeispiel beschränkt. Sie umfasst vielmehr auch alle fachmännischen Weiterbildungen im Rahmen der durch die Patentansprüche definierten Erfindung. So kann das erfindungsgemäße Schaltbedienelement nicht nur für Kraftfahrzeuge, also als Bedienschalter oder als mehrere Bedienschalter umfassendes Schaltbedienfeld im Automotive-Bereich, sondern auch als Schaltbedienelement im Consumer-Bereich, beispielsweise in Hausgeräten, Waschmaschinen, Kaffeeautomaten, Audiogeräten, Videogeräten, Telekommunikationsgeräten, Elektrowerkzeugen o. dgl. Verwendung finden.

### Bezugszeichen-Liste:

- 1:: Schaltbedienelement
- 2:: Funktionssymbol
- 3:: Funktionsanzeige
- 4:: Betätigungsfläche
- 5:: Element
- 6:: Sensor
- 7:: Dämpfungs- und/oder Rückstellelement / elastisches Element
- 8:: Betätigungselement
- 9:: Zapfen (am Betätigungselement)
- 10:: (zweite) Sensorelektrode
- 11:: Leiterplatte
- 12:: Kontaktfläche (an Dämpfungs- und/oder Rückstellelement)
- 13:: Verbindungsfläche (von Kontaktflächen)
- 14:: Gehäuse
- 15:: Inneres (von Gehäuse)
- 16:: Kraft
- 17:: Fläche (an Dämpfungs- und/oder Rückstellelement) / (erste) Sensorelektrode
- 18:: Noppe
- 19:: Federarm

## Patentansprüche

1. Schaltbedienelement, insbesondere für ein Kraftfahrzeug, mit einer durch manuelle Krafteinwirkung mittels eines Elements (5) bewegbaren Betätigungsfläche (4), wobei es sich insbesondere bei dem Element (5) um den Finger einer menschlichen Hand handelt, und mit einem mit der Betätigungsfläche (4) derart zusammenwirkenden Sensor (6), dass der Sensor (6) bei Bewegung der Betätigungsfläche (4) mittels des Elements (5) ein Signal erzeugt, wobei insbesondere das Signal zum Schalten und/oder Auslösen einer Funktion in der Art eines Schaltsignals dient, wobei ein mit der Betätigungsfläche (4) bei deren Bewegung zusammenwirkendes Dämpfungs- und/oder Rückstellelement (7) vorgesehen ist und das Dämpfungs- und/oder Rückstellelement (7) ein Bestandteil des Sensors (6) ist, wobei das mechanische Dämpfungs- und/oder Rückstellelement (7) in den Sensor (6) und/oder der Sensor (6) in das Dämpfungs- und/oder Rückstellelement (7) integriert ist, wobei das Dämpfungs- und/oder Rückstellelement (7) als eine erste elektrische Sensorelektrode (17) für den Sensor (6) dient, wobei das Dämpfungs- und/oder Rückstellelement (7) als ein elastisches Element ausgestaltet ist, das Kontaktflächen (12) für die elektrische Kontaktierung aufweist, **dadurch gekennzeichnet, dass** an der Verbindungsfläche (13) der Kontaktflächen (12),) in etwa mittig zwei einander gegenüberliegende, in etwa rechteckförmige Flächen (17) für die Zusammenwirkung mit dem Betätigungselement (8) angeordnet sind, wobei die Fläche (17) die erste Sensorelektrode (17) bildet, und dass eine Noppe (18) an der Fläche (17) zur Zusammenwirkung mit einem Zapfen (9) am Betätigungselement (8) angeordnet ist.

2. Schaltbedienelement nach Anspruch 1, **dadurch gekennzeichnet, dass** ein Betätigungselement (8) an der Betätigungsfläche (4) angeordnet ist, dass vorzugsweise das Betätigungselement (8) auf das Dämpfungs- und/oder Rückstellelement (7) einwirkt, dass weiter vorzugsweise das Dämpfungs- und/oder Rückstellelement (7) sich bei Krafteinbringung auf die Betätigungsfläche (4) in etwa planparallel bewegt, und dass noch weiter vorzugsweise das Betätigungselement (8) bei Bewegung der Betätigungsfläche (4) mit dem Dämpfungs- und/oder Rückstellelement (7) zur Signalerzeugung zusammenwirkt.

3. Schaltbedienelement nach Anspruch 1 oder 2, **dadurch gekennzeichnet, dass** eine weitere elektrische Sensorelektrode (10) für den Sensor (6) vorgesehen ist, derart dass die beiden Sensorelektroden (17, 10) einen kapazitiven Sensor bilden, und dass vorzugsweise die durch die Bewegung des Dämpfungs- und/oder Rückstellelements (7) bewirkte Abstandsänderung (Δd) der beiden Sensorelektroden (17, 10) zueinander die Kapazität des Sensors (6) verändert, wobei insbesondere die Kapazitätsveränderung (ΔC) des Sensors (6) für die Erzeugung des Signals dient.

4. Schaltbedienelement nach Anspruch 1, 2 oder 3, **dadurch gekennzeichnet, dass** eine Leiterplatte (11) vorgesehen ist, dass vorzugsweise das Dämpfungs- und/oder Rückstellelement (7) an und/oder auf der Leiterplatte (11) angeordnet ist, dass weiter vorzugsweise das Dämpfungs- und/oder Rückstellelement (7) mit der Leiterplatte (11) zur Ausbildung der ersten Sensorelektrode (17) elektrisch kontaktiert ist, dass noch weiter vorzugsweise die zweite Sensorelektrode (10) durch Leiterbahnen, insbesondere in der Art von Kupferflächen, auf der Leiterplatte (11) gebildet ist, und dass nochmals weiter vorzugsweise die erste Sensorelektrode (17) am Dämpfungs- und/oder Rückstellelement (7) bei Krafteinwirkung auf die Betätigungsfläche (4) sich in etwa planparallel zur zweiten Sensorelektrode (10) auf der Leiterplatte (11) bewegt.

5. Schaltbedienelement nach einem der Ansprüche 1 bis 4, **dadurch gekennzeichnet, dass** es sich bei dem Dämpfungs- und/oder Rückstellelement (7) um ein mechanisches Dämpfungs- und/oder Rückstellelement handelt.

6. Schaltbedienelement nach einem der Ansprüche 1 bis 5, **dadurch gekennzeichnet, dass** das Dämpfungs- und/oder Rückstellelement (7) in der Art eines blattfederartigen Federelements, ausgestaltet ist, dass vorzugsweise das elastische Element (7) in etwa H-förmig ausgestaltete Kontaktflächen (12) für die elektrische Kontaktierung zur Leiterplatte (11) aufweist, und dass weiter vorzugsweise die Verbindungsfläche (13) der Kontaktflächen (12) elastische Federarme (19) umfasst.

7. Schaltbedienelement nach einem der Ansprüche 1 bis 6, **dadurch gekennzeichnet, dass** die in etwa mittig zwei einander gegenüberliegende, in etwa rechteckförmige Flächen (17) für die Zusammenwirkung mit dem Betätigungselement (8) an den Federarmen (19) angeordnet sind

8. Schaltbedienelement nach einem der Ansprüche 1 bis 7, **dadurch gekennzeichnet, dass** das Dämpfungs- und/oder Rückstellelement (7) aus Metall besteht, und dass vorzugsweise das Dämpfungs- und/oder Rückstellelement (7) in der Art eines Stanz-Biege-Teils hergestellt ist.

9. Schaltbedienelement nach einem der Ansprüche 1 bis 8, **dadurch gekennzeichnet, dass** ein Gehäuse (14) vorgesehen ist, dass vorzugsweise die Betätigungsfläche (4) eine, insbesondere weitgehend geschlossene, Oberfläche am Gehäuse (14) bildet, und dass weiter vorzugsweise das Dämpfungs- und/oder Rückstellelement (7) und/oder die Leiterplatte (11) im Inneren (15) des Gehäuses (14) befindlich sind.

10. Schaltbedienelement nach einem der Ansprüche 1 bis 9, **dadurch gekennzeichnet, dass** das Dämpfungs- und/oder Rückstellelement (7) ein Bestandteil eines induktiven Sensors, eines Magnetsensors, eines Hallsensors o. dgl. ist.

## Claims

1. A shift operating element, in particular for a motor vehicle, comprising an actuation surface (4), which can be moved by manual application of force by means of an element (5), wherein the element (5) is in particular the finger of a human hand, and comprising a sensor (6), which interacts with the actuation surface (4) such that the sensor (6) generates a signal when the actuation surface (4) is moved by means of the element (5), wherein the signal in particular serves to shift and/or trigger a function in the form of a shift signal, wherein a damping and/or restoring element (7) is provided, which interacts with the actuation surface (4) when the latter is moved, and the damping and/or restoring element (7) is a part of the sensor (6), wherein the mechanical damping and/or restoring element (7) is integrated into the sensor (6) and/or the sensor (6) is integrated into the damping and/or restoring element (7), wherein the damping and/or restoring element (7) serves as a first electrical sensor electrode (17) for the sensor (6), wherein the damping and/or restoring element (7) is designed as an elastic element, which has contact surfaces (12) for the electrical contacting, **characterized in that** two approximately centrally mutually opposing, approximately rectangular surfaces (17) are arranged at the connecting surface (13) of the contact surfaces (12) for the interaction with the actuation element (8), wherein the surface (17) forms the first sensor electrode (17), and that a nub (18) is arranged at the surface (17) for interaction with a pin (9) at the actuation element (8).

2. A shift operating element according to claim 1, **characterized in that** an actuation element (8) is arranged at the actuation surface (4), that the actuation element (8) preferably acts on the damping and/or restoring element (7), that the damping and/or restoring element (7) further preferably moves in an approximately plane-parallel manner upon application of a force to the actuation surface (4), and that the actuation element (8) even further preferably interacts with the damping and/or restoring element (7) when the actuation surface (4) is moved, to generate a signal.

3. The shift operating element according to claim 1 or 2, **characterized in that** a further electrical sensor electrode (10) is provided for the sensor (6) such that the two sensor electrodes (17, 10) form a capacitive sensor, and that the change in distance (Δd), which is effected by the movement of the damping and/or restoring element (7), of the two sensor electrodes (17, 10) to one another, preferably changes the capacitance of the sensor (6), wherein the change in capacitance (ΔC) of the sensor (6) in particular serves to generate the signal.

4. The shift operating element according to claim 1, 2, or 3, **characterized in that** a circuit board (11) is provided, that the damping and/or restoring element (7) is preferably arranged at and/or on the circuit board (11), that the damping and/or restoring element (7) is further preferably electrically contacted with the circuit board (11) for forming the first sensor electrode (17), that the second sensor electrode (10) is even further preferably formed on the circuit board (11) by printed conductors, in particular in the form of copper surfaces, and that the first sensor electrode (17) at the damping and/or restoring element (7) even further preferably moves in an approximately plane-parallel manner to the second sensor electrode (10) on the circuit board (11) upon application of a force to the actuation surface (4).

5. The shift operating element according to any one of claims 1 to 4, **characterized in that** the damping and/or restoring element (7) is a mechanical damping and/or restoring element.

6. The shift operating element according to any one of claims 1 to 5, **characterized in that** the damping and/or restoring element (7) is designed in the form of a leaf-spring-like spring element, that the elastic element (7) preferably has contact surfaces (12), which are designed in an approximately H-shaped manner, for electrically contacting the circuit board (11), and that the connecting surface (13) of the contact surfaces (12) further preferably comprises elastic spring arms (19).

7. The shift operating element according to any one of claims 1 to 6, **characterized in that** two approximately centrally mutually opposing, approximately rectangular surfaces (17) are arranged at the spring arms (19) for the interaction with the actuation element (8).

8. The shift operating element according to any one of claims 1 to 7, **characterized in that** the damping and/or restoring element (7) consist of metal and that the damping and/or restoring element (7) is preferably made in the form of a stamped and bent part.

9. The shift operating element according to any one of claims 1 to 8, **characterized in that** a housing (14) is provided, that the actuation surface (4) preferably forms an in particularly largely closed surface at the housing (14), and that the damping and/or restoring element (7) and/or the circuit board (11) are further preferably located in the interior (15) of the housing (14).

10. The shift operating element according to any one of claims 1 to 9, **characterized in that** the damping and/or restoring element (7) is a part of an inductive sensor, of a magnetic sensor, of a Hall sensor, or the like.

## Revendications

1. Organe de commande de commutation, en particulier pour un véhicule automobile, doté d'une surface d'actionnement (4) mobile par application de force manuelle au moyen d'un élément (5), l'élément (5) étant notamment le doigt d'une main humaine, et d'un détecteur (6) interagissant avec la surface d'actionnement (4) de telle sorte que le détecteur (6) génère un signal lors d'un mouvement de la surface d'actionnement (4) au moyen de l'élément (5), le signal permettant en particulier l'activation et/ou le déclenchement d'une fonction à la manière d'un signal de commutation, un élément d'amortissement et/ou de rappel (7) interagissant avec la surface d'actionnement (4) lors de son mouvement étant prévu et l'élément d'amortissement et/ou de rappel (7) faisant partie du détecteur (6), l'élément d'amortissement et/ou de rappel (7) mécanique étant intégré dans le détecteur (6) et/ou le détecteur (6) étant intégré dans l'élément d'amortissement et/ou de rappel (7), l'élément d'amortissement et/ou de rappel (7) faisant office de première électrode de détection électrique (17) pour le détecteur (6), l'élément d'amortissement et/ou de rappel (7) étant conçu comme un élément élastique qui présente des surfaces de contact (12) pour le contact électrique, **caractérisé en ce que**
deux surfaces approximativement rectangulaires (17), opposées l'une à l'autre à peu près au centre, sont disposées sur la surface de liaison (13) des surfaces de contact (12) pour l'interaction avec l'élément d'actionnement (8), la surface (17) formant la première électrode de détection (17) et qu'une protubérance (18) est disposée sur la surface (17) pour une interaction avec un tenon (9) sur l'élément d'actionnement (8).

2. Organe de commande de commutation conformément à la revendication 1, **caractérisé en ce qu'**un élément d'actionnement (8) est disposé sur la surface d'actionnement (4), que préférablement l'élément d'actionnement (8) agit sur l'élément d'amortissement et/ou de rappel (7), que plus préférablement l'élément d'amortissement et/ou de rappel (7) se déplace à peu près sur un plan parallèle lorsqu'une force est appliquée sur la surface d'actionnement (4) et qu'encore plus préférablement l'élément d'actionnement (8) interagit avec l'élément d'amortissement et/ou de rappel (7) pour la génération d'un signal lors d'un mouvement de la surface d'actionnement (4).

3. Organe de commande de commutation conformément à la revendication 1 ou 2, **caractérisé en ce qu'**une autre électrode de détection électrique (10) est prévue pour le détecteur (6) de façon à ce que les deux électrodes de détection (17, 10) forment un détecteur capacitif et que préférablement la variation de distance (Δd) entre les deux électrodes de détection (17, 10), entraînée par le mouvement de l'élément d'amortissement et/ou de rappel (7), modifie la capacité du détecteur (6), la variation de capacité (ΔC) du détecteur (6) permettant en particulier la génération du signal.

4. Organe de commande de commutation conformément à la revendication 1, 2 ou 3, **caractérisé en ce qu'**un circuit imprimé (11) est prévu, que préférablement l'élément d'amortissement et/ou de rappel (7) est disposé contre et/ou sur le circuit imprimé (11), que plus préférablement l'élément d'amortissement et/ou de rappel (7) est en contact électrique avec le circuit imprimé (11) pour la formation de la première électrode de détection (17), qu'encore plus préférablement la deuxième électrode de détection (10) est formée sur le circuit imprimé (11) par des pistes conductrices, notamment à la manière de surfaces de cuivre, et qu'encore bien plus préférablement la première électrode de détection (17) sur l'élément d'amortissement et/ou de rappel (7) se déplace à peu près sur un plan parallèle par rapport à la deuxième électrode de détection (10) sur le circuit imprimé (11) lorsqu'une force est appliquée sur la surface d'actionnement (4).

5. Organe de commande de commutation conformément à l'une des revendications 1 à 4, **caractérisé en ce que** l'élément d'amortissement et/ou de rappel (7) est un élément d'amortissement et/ou de rappel mécanique.

6. Organe de commande de commutation conformément à l'une des revendications 1 à 5, **caractérisé**
**en ce que** l'élément d'amortissement et/ou de rappel (7) est conçu à la manière d'un élément à ressort en forme de ressort à lames, que préférablement l'élément élastique (7) présente des surfaces de contact (12) approximativement en forme de H pour le contact électrique avec le circuit imprimé (11) et que plus préférablement la surface de liaison (13) des surfaces de contact (12) comprend des bras à ressort élastiques (19).

7. Organe de commande de commutation conformément à l'une des revendications 1 à 6, **caractérisé en ce que** les deux surfaces approximativement rectangulaires (17), opposées l'une à l'autre à peu près au centre, sont disposées sur les bras à ressort (19) pour l'interaction avec l'élément d'actionnement (8).

8. Organe de commande de commutation conformément à l'une des revendications 1 à 7, **caractérisé en ce que** l'élément d'amortissement et/ou de rappel (7) se compose de métal et que de préférence l'élément d'amortissement et/ou de rappel (7) est fabriqué à la manière d'une pièce d'estampage-pliage.

9. Organe de commande de commutation conformément à l'une des revendications 1 à 8, **caractérisé en ce qu'**un boîtier (14) est prévu, que préférablement la surface d'actionnement (4) forme une surface en particulier largement fermée sur le boîtier (14) et que plus préférablement l'élément d'amortissement et/ou de rappel (7) et/ou le circuit imprimé (11) se trouvent à l'intérieur (15) du boîtier (14).

10. Organe de commande de commutation conformément à l'une des revendications 1 à 9, **caractérisé en ce que** l'élément d'amortissement et/ou de rappel (7) fait partie d'un détecteur inductif, d'un détecteur magnétique, d'un capteur à effet Hall ou similaire.
